Europäisches Patentamt

European Patent Office

Office européen des brevets

(19)

(11) Numéro de publication: **0 378 452**
**A1**

## (12) DEMANDE DE BREVET EUROPEEN

(21) Numéro de dépôt: **90400023.9**

(22) Date de dépôt: **04.01.90**

(51) Int. Cl.⁵: **G05F 3/26**

(30) Priorité: **11.01.89 FR 8900275**

(43) Date de publication de la demande:
**18.07.90 Bulletin 90/29**

(84) Etats contractants désignés:
**AT BE DE FR GB IT NL**

(71) Demandeur: **SGS-THOMSON**
**MICROELECTRONICS S.A.**
**7, avenue Galliéni**
**F-94253 Gentilly Cédex(FR)**

(72) Inventeur: **Bernard, Patrick**
**22, Rue du Rachais, Poisat**
**F-38329 Eybens(FR)**

(74) Mandataire: **Rinuy, Santarelli**
**14, avenue de la Grande Armée**
**F-75017 Paris(FR)**

(54) **Perfectionnement aux circuits miroirs de courants.**

(57) Circuit miroir de courant du genre comportant une branche primaire (12) destinée à être parcourue par un courant maître ($I_1$) et au moins une branche secondaire (13, 13′) destinée à être parcourue par un courant image ($I_2$) de caractéristiques sensiblement égales à celles du courant maître, au moins deux transistors identiques de type à effet de champ (M1, M2) raccordés entre eux par leur grille, et raccordés par leur drain et leur source en série respectivement dans lesdites branches primaire (12) et secondaire (13) du circuit (10), caracterisé en ce qu'il comporte un moyen de décalage de tension ($\delta V$) interposé, en dehors de la branche primaire du circuit, entre le drain et la source du transistor monté en série dans la branche primaire (12) du circuit.

FIG 1a

## Perfectionnement aux circuits miroirs de courants

La présente invention concerne un perfectionnement aux circuits miroirs de courant.

De tels circuits sont des circuits comportant, d'une manière générale, une branche primaire destinée à être parcourue par un courant, que l'on appelera courant "maître", et une ou plusieurs branches secondaires destinées à être parcourues chacune par un courant image de caractéristiques sensiblement égales à celles du courant maître.

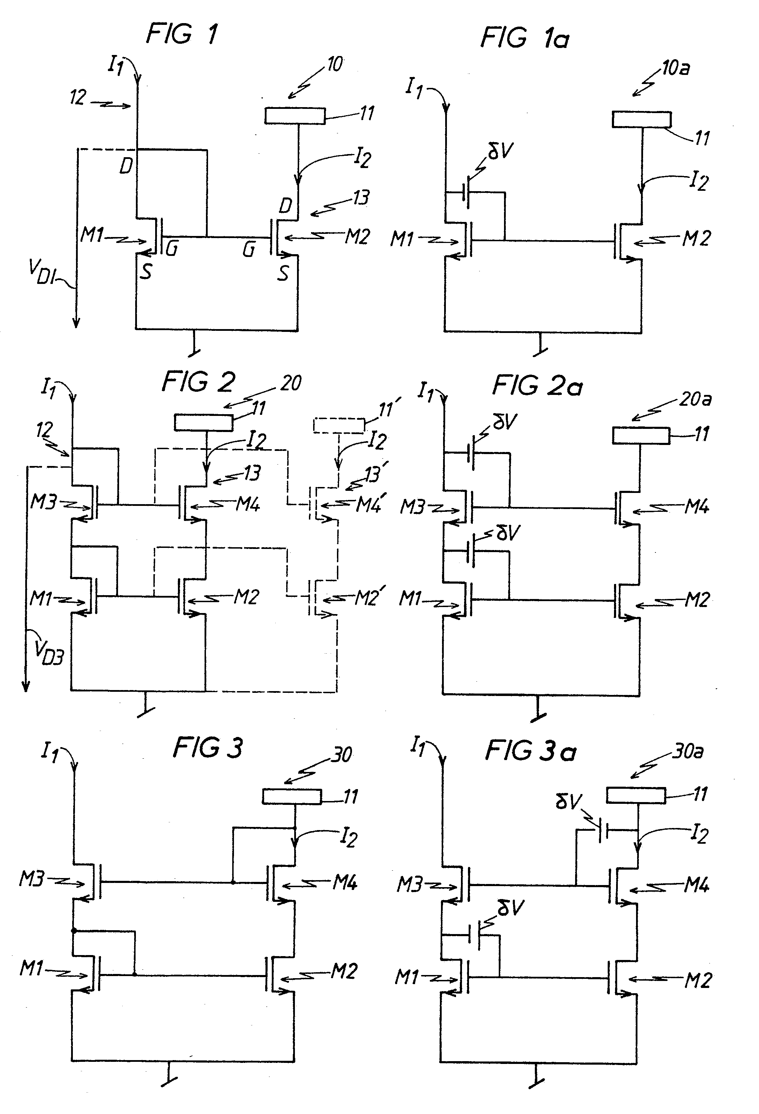

Une forme classique de réalisation d'un tel circuit est illustrée en figure 1. Elle met en oeuvre deux transistors à effet de champ de type MOS-N référencés en M1 et M2. Ces transistors sont de géométrie identique et constituent respectivement la branche primaire 12 et la branche secondaire 13 du circuit miroir de courant 10. Ils sont raccordés par leurs grilles (G) tandis que leurs sources (S) sont toutes deux mises à la masse. La grille (G) et le drain (D) du transistor M1 sont reliés. Le drain (D) du transistor M2 est raccordé à une charge 11.

Ce circuit, bien connu de l'homme de l'art fonctionne de la manière suivante. Comme la grille et le drain du transistor M1 sont au même potentiel, ce dernier est dans un état saturé. Par ailleurs la charge 11 est telle que le transistor M2 est également dans un état saturé. De plus, comme dans le circuit de la figure 1, les potentiels de grille et de source des deux transistors sont identiques il s'ensuit qu'ils sont alors traversés par des courants théoriquement identiques ($I_2 = I_1$).

En effet, on sait que le courant drain-source ($I_{DS}$) dans un FET est régi par l'equation suivante:

$$I_{DS} = \mu_o \text{ Cox } W/L \text{ } (V_{GS} - V_T)^2 (1 + \alpha V_{DS}) \qquad (2)$$

où

$I_{DS}$ : courant circulant entre le drain et la source d'un transistor MOS. ($I_{DS} = I_1 = I_2$ théoriquement)

$\alpha$, $\mu_0$, Cox, W/L, : grandeurs caractéristiques du transistor MOS considéré

$V_{GS}$ : tension grille-source

$V_{DS}$ : tension drain-source

Ainsi le courant $I_2$ parcourant la branche secondaire 13 du circuit 10, présente-t-il, sensiblement les mêmes caractéristiques que celles du courant $I_1$ parcourant la branche primaire 12.

Il est cependant bien connu de l'homme de l'art que l'égalité des courants $I_1$ et $I_2$ n'est en l'espèce vraie qu'au premier ordre dans un circuit miroir de courant tel que celui illustré en Figure 1. En effet la différence de potentiel existant entre le drain et la source des transistors M1 ou M2 intervient dans l'équation donnant le courant circulant entre le drain et la source de chacun des transistors. Ainsi il est connu qu'un écart de la différence de potentiel entre le drain et la source de l'ordre du volt pour chacun des transistors M1, M2 entraîne une variation de l'amplitude du courant drain-source $I_2$ de l'ordre de quelques centièmes.

Une telle variation peut être préjudiciable dans certaines applications et c'est la raison pour laquelle, dans l'art antérieur, à partir du circuit illustré en Figure 1, on a développé d'autres circuits miroir de courant qui ont été illustrés en Figures 2 et 3.

En Figure 2 il est illustré un circuit miroir de courant connu sous l'appellation de "cascode". Un tel circuit comporte deux paires de transistors MOS identiques M1 et M2, d'une part et M3 et M4, d'autre part. Les paires de transistors M1, M2 et M3, M4 doivent respectivement présenter la même structure et les mêmes caractéristiques dimensionnelles. En revanche un transistor d'une paire peut présenter une structure différente d'un transistor de l'autre paire. Comme dans le circuit de la Figure 1 le circuit 20 illustré en Figure 2 présente une branche primaire 12 et une branche secondaire 13. Les transistors M1 et M3 sont raccordés en série par leur drain et leur source dans la branche primaire 12, tandis que les transistors M2 et M4 sont raccordés en série par leur drain et leur source dans la branche secondaire 13. On observe que la source des transistors M1 et M2 est, comme dans le circuit 10 illustré en Figure 1, mise à la masse, tandis que le drain des transistors M1 et M2 est raccordé à la source des transistors M3 et M4. On observe également que le drain et la source du transistor M1 d'une part et M3 d'autre part sont raccordés. La branche secondaire 13 est raccordée à une charge 11.

L'ensemble des transistors M1-M4 fonctionne en régime saturé. Ceci est notamment visible pour les transistors M1 et M3 dont la grille est reliée au drain. En revanche la saturation des transistors M4 et M2 est imposée par la tension en sortie de la charge 11. Dans ces conditions, la structure des transistors M1 et M2 d'une part et M3 et M4 d'autre part étant identique, le circuit 20 illustré en Figure 2 se comporte comme un miroir de courant, le courant $I_2$ de la branche secondaire 13 présentant les mêmes caractéristiques que le courant $I_1$ de la branche primaire 12. Par rapport au circuit 10 illustré en Figure 1 le montage cascode illustré en Figure 2 présente une bien meilleure capacité de miroir de courant. On sait en effet que les différences subsistant entre les caractéristiques du courant $I_1$ et celles du courant $I_2$ ont été réduites d'un rapport de 100 environ par rapport au circuit illustré en Figure 1.

Sur la Figure 2 il est illustré également en traits mixtes le fait qu'un circuit cascode peut comporter plusieurs branches secondaires. L'une de ces dernières a été représentée et comporte des transistors M2$'$ et M4$'$ montés en série entre une charge 11$'$ et la masse, la grille des transistors M2$'$ d'une part et M4$'$ d'autre part étant respectivement raccordée à la grille des transistors M2 et M4. Dans un tel circuit le courant I$_2$ circulant dans la branche secondaire 13$'$ est identique au courant I$_2$ circulant dans la branche secondaire 13, ces deux courants présentent les mêmes caractéristiques ou à tout le moins, des caractéristiques très proches du courant I$_1$ circulant dans la branche primaire 12, comme exposé plus haut.

En Figure 3 on a illustré une variante du circuit cascode de la Figure 2. Cette variante qui est connue sous le nom de "circuit de Wilson" se distingue du circuit de la Figure 2 en ce que la grille et le drain du transistor M3 ne sont pas reliés tandis que la grille et le drain du transistor M4 le sont. Les performances d'un tel circuit comme miroir de courant sont semblables à celles du circuit cascode illustré en Figure 2.

Les circuits des Figures 2 et 3 donnent en général satisfaction sur le plan de leurs capacités comme miroir de courant. Il en est de même pour d'autres applications moins exigeantes sur le plan de la précision du courant I$_2$, du circuit de la Figure 1. Cependant ces circuits présentent, pour certaines applications, un défaut particulièrement marqué pour les circuits cascode et Wilson : la tension nécessaire pour assurer le fonctionnement de ces circuits est assez élevée et avoisine en général les 5 volts.

En effet, en prenant l'exemple du circuit de la Figure 2, on sait que, sur le plan théorique tout au moins, pour que ce circuit fonctionne il faut que le potentiel de drain du transistor M3 (V$_{D3}$) soit supérieur à la somme des tensions de seuil des transistors M1 et M3 ce qui dans le cas où les transistors M1 et M3 sont de structure identique s'exprime par l'inégalité suivante :

$$V_{D3} \geqq 2V_T \qquad (1)$$

où :

V$_{D3}$ : potentiel du drain du transistor M3
V$_T$ : tension de seuil des transistors M1 et M3.

Or, l'ordre de grandeur de la tension de seuil V$_T$ est, dans les meilleures conditions de 1 volt et dans les plus mauvaises conditions d'environ 1,5 volt. De plus, pour assurer une bonne conduction, il faut prévoir une certaine marge en tension de grille car, en pratique, la tension grille/source (V$_{GS}$) doit en réalité être supérieure à la tension de seuil V$_T$ de chacun des transistors. Enfin on sait que pour générer un courant I$_1$ dans la branche primaire il faut prévoir une certaine chute de potentiel.

En pratique la tension minimale V$_{MIN}$ d'alimentation du circuit est donnée par la formule suivante :

$$V_{MIN} = 2V_T + 2V_M + V_F \qquad (3)$$

où

V$_T$ : tension de seuil fixée à 1,5 V dans cet exemple

V$_M$ : marge de tension pour assurer la conduction de chaque transistor (en pratique 0,4V)

V$_F$ : tension de fonctionnement destinée à générer le courant I$_{DS}$ (théoriquement V$_F$ = V$_{GS}$ - V$_T$)
Cette tension est fixée par l'utilisateur mais sera en pratique de l'ordre de 1 V.

Il s'ensuit qu'en pratique la tension minimale d'alimentation du circuit cascode de la Figure 2 sera :

V$_{MIN}$ = 4,8 V

Il en est de même du montage de Wilson illustré en Figure 3.

S'agissant du circuit illustré en Figure 1 ce dernier nécessite en pratique, pour les mêmes raisons, une tension minimale d'alimentation de 2,9 V.

Or, dans certaines applications, il est souhaitable de pouvoir disposer d'un miroir de courant précis (du type cascode ou Wilson) susceptible de pouvoir être alimenté par une tension relativement faible (nettement inférieure à 4,8 V dans l'exemple ci-dessus). De même dans certaines applications il est nécessaire de pouvoir disposer d'un montage miroir de courant tel que celui illustré en Figure 1 susceptible d'être alimenté lui aussi par une tension relativement faible (inférieure à 2,9 V dans l'exemple illustré ci-dessus).

La présente invention résout ce problème technique en prévoyant, d'une manière générale, un moyen de décalage de tension interposé entre le drain et la source de chaque transistor dont le drain est relié à la source dans les montages illustrés au Figures 1 à 3. Ainsi :
- dans le circuit illustré en Figure 1 la présente invention prévoit un moyen de décalage de tension interposé, en dehors de la branche primaire du circuit, entre le drain et la grille du transistor monté en série dans la branche primaire du circuit miroir de courant ;
- dans le circuit illustré en Figure 2 la présente invention prévoit un moyen de décalage de tension interposé, en dehors de la branche primaire du circuit, entre le drain et la grille de chaque transistor monté en série dans la branche primaire du circuit miroir de courant ;
- dans le circuit illustré en Figure 3 la présente invention prévoit un moyen de décalage de tension interposé, en dehors de la branche primaire du circuit, entre le drain et la grille du transistor monté en série dans la branche primaire du circuit miroir de courant, et appartenant à l'un des deux ensembles de transistors, et un moyen de décalage de tension interposé, en dehors de la branche secondaire du circuit, entre le drain et la grille du transistor monté en série dans la branche secondaire du circuit, et appartenant à l'autre ensemble.

Grâce à ces dispositions il est possible, théoriquement tout au moins, d'abaisser la tension d'alimentation des montages cascode et Wilson illustrés en Figures 2 et 3, de l'équivalent de deux tensions de seuil, ($2V_T$) tandis qu'il est possible d'abaisser la tension d'alimentation du montage illustré en Figure 1 de l'équivalent d'une tension de seuil ($V_T$).

Les caractéristiques et avantages ressortiront d'ailleurs de la description qui va suivre en référence aux dessins annexés sur lesquels la ligne des Figures 1 à 3 a déjà été décrite :

- les Figures 1a à 3a sont des figures équivalentes aux figures 1 à 3 illustrant la mise en oeuvre de l'invention dans ces circuits ;

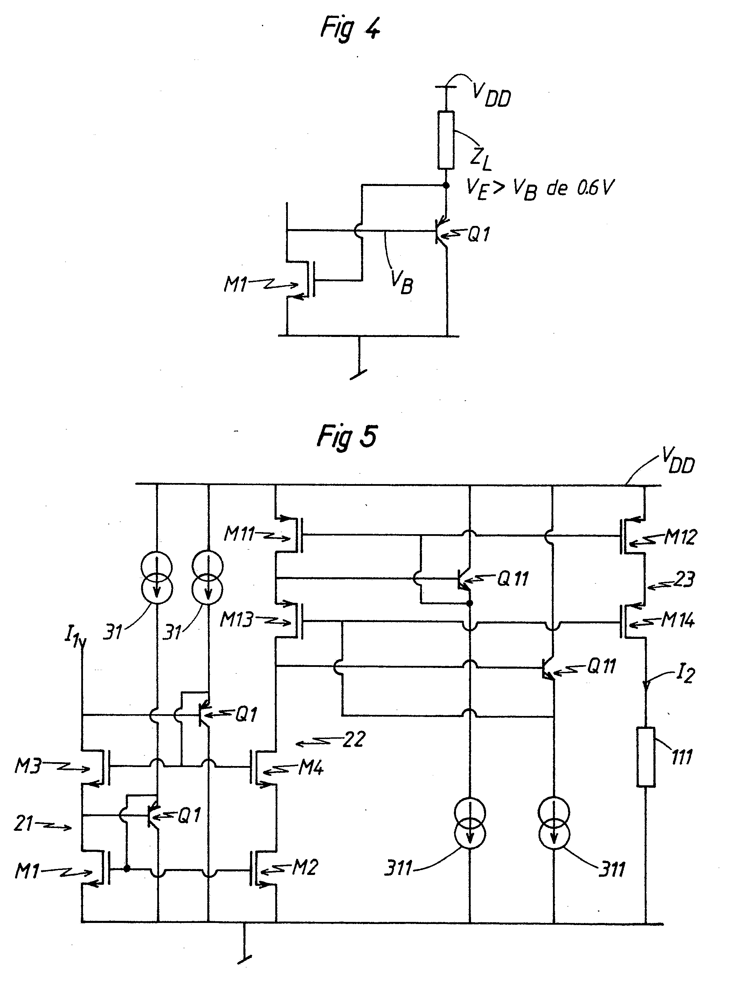

- la Figure 4 illustre un mode de réalisation d'un moyen de décalage de tension conforme à l'invention ; et

- la Figure 5 est un schéma général illustrant un mode de réalisation d'un circuit miroir de courant conforme à l'invention.

Sur les Figures 1a à 3a les éléments identiques à ceux des Figures 1 à 3 conservent les mêmes références.

Globalement les circuits illustrés aux Figures 1a à 3a sont semblables à ceux déjà décrits à l'appui des Figures 1 à 3. On observe que là où, dans les circuits illustrés aux Figures 1 à 3, la grille et le drain d'un transistor sont reliés entre eux, un moyen de décalage de tension (source de tension $\delta V$) a été interposé.

Les avantages d'une telle disposition vont être expliqués ci-après en se référant aux circuits cascode illustrés en Figure 2 et 2a. On sait que pour que le circuit illustré en Figure 2 puisse fonctionner il faut que la tension $V_{D3}$ soit égale à $V_{MIN}$ - (équation (3) ci-dessus).

En interposant une source de tension $\delta V$ entre le drain et la grille du transistor M1 d'une part et le drain et la grille du transistor M2 d'autre part, la source $\delta V$ ainsi associée au transistor M1 étant, dans ce mode de réalisation, de même valeur que celle associée au transistor M3, l'inégalité (1) énoncée plus haut devient :

$$V_{D3} \geqq 2V_T - 2\delta V$$

Ainsi on observe que l'on peut choisir une source de tension $\delta V$ positive éventuellement égale à la tension de seuil, le schéma cascode de la Figure 2 fonctionnant alors pour autant que le potentiel de drain du transistor M3 soit sensiblement positif.

En réalité, dans l'expression de la tension $V_{MIN}$ (équation (3)) le facteur $2V_T$ peut être annulé de telle sorte que la tension d'alimentation du montage en cascode peut être réduite à la somme des termes $2V_M$ et $V_F$ soit à 1,8 V dans l'exemple considéré.

Des considérations semblables permettent d'aboutir à la même conclusion pour ce qui est des circuits de type Wilson illustrés respectivement en Figure 3 (art antérieur) et en Figure 3a (mise en oeuvre de l'invention).

Pour ce qui est des schémas illustrés en Figures 1 et 1a la tension d'alimentation baisse de 2,9 V environ (Figure 1) à 1,4 V (Figure 1a).

On va maintenant décrire à l'appui de la Figure 4 un mode de réalisation d'un moyen de décalage de tension conforme à l'invention.

On reconnaît sur la Figure 4 le transistor M1 mis en oeuvre dans les schémas des Figures 1a et 2a. Entre la grille et la source du transistor M1 on interpose une source de tension constituée en l'espèce par la jonction base-émetteur d'un transistor bipolaire de type PNP. Le transistor bipolaire PNP porte sur cette figure la référence Q1. Son collecteur est raccordé à la masse tandis que son émetteur est raccordé, d'une part à la grille du transistor M1 et d'autre part à la seconde borne d'une charge $Z_L$ elle-même raccordée à un potentiel de référence $V_{DD}$. La base du transistor Q1 est raccordée au drain du transistor M1.

Le potentiel $V_{DD}$ et la charge $Z_L$ sont tels que le transistor Q1 est conducteur. Dans ces conditions le potentiel de l'émetteur du transistor Q1 est supérieur à celui de sa base de 0,6 volt.

La jonction base-émetteur du transistor Q1 équivaut ainsi à la source de tension $\delta V$ associée au transistor M1 sur les Figures 1a et 2a, la source de tension $\delta V$ étant de 0,6 volt.

Il est également possible de prévoir, conformément à cet aspect de l'invention, de réaliser la source de tension associée au transistor M3 (Figure 2a) et M2 (Figure 3a) au moyen d'un montage mettant en oeuvre un transistor bipolaire tel que le transistor Q1.

On va maintenant décrire à l'appui de la Figure 5 un mode de réalisation d'un circuit miroir de courant mettant en oeuvre les enseignements de l'invention exposés ci-dessus à l'appui des Figures 2a et 4. Sur la Figure 5 les éléments ayant dans ce circuit les mêmes fonctions que certains éléments illustrés en Figure 2a ou 4 portent les mêmes références.

Le circuit de la Figure 5 comporte trois branches : une branche primaire 21, une branche intermédiaire 22 et une branche secondaire 23. Le circuit est divisé en deux ensembles A et B, l'ensemble A consistant en un miroir de courant de type cascode de structure semblable à celle décrite à l'appui de la Figure 2a, la branche intermédiaire 22 constituant la branche secondaire du miroir de courant A. La partie référencée sous B en Figure 5 est une utilisation qui est ici aussi un miroir courant, la branche intermédiaire 22 commune aux ensembles A et B constituant la branche primaire du circuit miroir de courant B tandis que la branche 23 en est la branche secondaire et constitue la branche secondaire de l'ensemble du circuit de la Figure 5.

La branche primaire de l'ensemble A est constituée par deux transistors à effet de champ de type MOS-N M1 et M2 montés en série comme dans le cas du circuit illustré en Figure 2a. On observe que les sources de tension δV de la Figure 2a sont ici remplacées par des jonctions base-émetteur de deux transistors bipolaires Q1 de type PNP comme décrit à l'appui de la Figure 4. Toutefois la charge des transistors bipolaires Q1 est ici constituée par une source de courant 31 pouvant être realisée de toute façon connue de l'homme de l'art. Le Demandeur a en effet constaté qu'il est plus efficace dans certaines applications de prévoir, comme charge des transistors utilisés comme source de tension, une charge active car une telle charge prend moins de place dans le circuit intégré devant matérialiser le circuit de la Figure 5. La charge active 31 de chacun des transistors bipolaire Q1 pourra être réalisée de façon classique au moyen d'un transistor à effet de champ de type MOS-P monté en suiveur avec le transistor Q1. D'autres formes de réalisations connues de l'homme de l'art sont possibles.

La branche secondaire de l'ensemble miroir de courant A est constituée par les transistors MOS-N, M2 et M4 de la branche intermédiaire référencée en 22 sous la Figure 5.

Le miroir de courant constitué par l'ensemble B est la symétrique-inverse du miroir A, en ce qu'il est réalisé par des transistors MOS de type P et des transistors bipolaires de type NPN. Il comporte donc 4 transistors identiques MOS-P M11-M14 montés en cascode, des sources de tension constituées par les jonctions base-émetteur de deux transistors bipolaires Q11 de type NPN étant associés aux transistors M11 et M13, les jonctions base-émetteur des transistors Q11 constituant une source de tension négative de -0,6 V. Il est également prévu une charge 311 associée à chacun des transistors Q11.

On observe que les transistors M11-M13 constituent la branche primaire du circuit miroir de courant B de type cascode, la branche secondaire de ce circuit étant constituée par les transistors M12, M14. La source des transistors M1, M2 et le collecteur des transistors Q1 sont mis à la masse, tandis que la source des transistors M11, M12 et le collecteur des transistors Q11 sont mis à un potentiel de référence $V_{DD}$.

Le circuit de la Figure 5 fonctionne de la façon suivante : les transistors M1-M4 M11-M14, fonctionnent dans un état saturé qui leur est imposé pour les mêmes raisons que celles déjà expliquées plus haut. Dans ces conditions le courant circulant entre le drain et la source des transistors M2 et M4 présente les caractéristiques quasiment identiques à celui $l_1$ circulant dans la branche primaire 21 du circuit. Le courant circulant dans la branche intermédiaire 22 est le courant maître du circuit miroir de courant constitué par l'ensemble B et le courant $l_2$ en sortie de ce circuit présente en conséquence des caractéristiques semblables, ou même quasiment identiques, à celles du courant $l_1$.

L'avantage d'un tel montage est que l'ensemble du circuit de la Figure 5 se présente, au niveau de sa branche secondaire 23, comme une source de courant, la charge 111 étant montée en aval des transistors M12, M14 alors que le circuit illustré en Figure 2a est, au niveau de son utilisation, un circuit de type "puits de courant" la charge 11 étant montée en amont des transistors M2 et M4.

On observera qu'il est possible de dupliquer la branche secondaire 23 du circuit de la Figure 5 comme expliqué à l'appui de la Figure 2.

Bien entendu la présente invention ne se limite nullement aux modes de réalisation choisis et représentés mais englobe bien au contraire toute variante à la portée de l'homme de l'art.

**Revendications**

1. Circuit miroir de courant du genre comportant une branche primaire (12) destinée à être parcourue par un courant maître ($l_1$) et au moins une branche secondaire (13, 13') destinée à être parcourue par un courant image ($l_2$) de caractéristiques sensiblement égales à celles du courant maître, au moins deux transistors identiques de type à effet de champ (M1, M2) raccordés entre eux par leur grille, et raccordés par leur drain et leur source en série respectivement dans lesdites branches primaire (12) et secondaire (13) du circuit (10), caractérisé en ce qu'il comporte un moyen de décalage de tension (δV) interposé, en dehors de la branche primaire du circuit, entre le drain et la grille du transistor monté en série dans la branche primaire (12) du circuit.

2. Circuit miroir de courant du genre comportant une branche primaire (12) destinée à être parcouru par un courant maître ($l_1$) et au moins une branche secondaire (13) destinée à être parcourue par un courant image ($l_2$) de caractéristiques sensiblement égales à celles du courant maître, au moins deux ensembles (M1, M2 et M3, M4) d'au moins deux transistors identiques de type à effet champ raccordés entre eux par leur grille et raccordés par leur drain et leur source en série respectivement dans lesdites première et deuxième branches du circuit, caractérisé en ce qu'il comporte un moyen de décalage de tension (δV) interposé, en dehors de la branche primaire du circuit, entre le drain et la grille du transistor (M1) monté en série dans la branche primaire (12), appartenant à l'un desdits ensembles et un moyen de décalage de tension ($\delta V$) interposé, en dehors de la branche secondaire du circuit, entre le drain et la grille du transistor (M4) monté en série dans la branche secondaire (13), appartenant à l'autre ensemble.

3. Circuit miroir de courant du genre comportant une branche primaire (12) destinée à être parcourue par un courant maître ($I_1$) et au moins une branche secondaire (13) destinée à être parcourue par un courant image ($I_2$) de caractéristiques sensiblement égales à celles du courant maître, au moins deux ensembles (M1, M2 et M3, M4) d'au moins deux transistors identiques de type à effet champ raccordés entre eux par leur grille et raccordés par leur drain et leur source en série respectivement dans lesdites première (12) et deuxième (13) branches du circuit, caractérisé en ce qu'il comporte un moyen de décalage de tension ($\delta V$) interposé, en dehors de la branche primaire du circuit, entre le drain et la grille de chaque transistor (M1, M3) monté en série dans la branche primaire (12) du circuit (10).

4. Circuit selon l'une quelconque des revendications 1 à 3, caractérisé en ce que le moyen de décalage de tension ($\delta V$) comporte au moins un transistor bipolaire (Q1, Q11) agencé de telle sorte qu'en fonctionnement il est conducteur, le décalage de tension étant constitué pour partie au moins par la différence de potentiel ($V_{BE}$) existant alors entre la base et l'emetteur de ce transistor.

FIG 1

FIG 1a

FIG 2

FIG 2a

FIG 3

FIG 3a

## Fig 4

$V_{DD}$

$Z_L$

$V_E > V_B$ de 0.6 V

Q1

$V_B$

M1

## Fig 5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | US-A-3953807 (SCHADE, JR)<br>* colonne 5, lignes 11 - 46; figure 4 *<br>--- | 1, 4 | G05F3/26 |
| A | GB-A-2071953 (N.V. PHILIPS GLOEILAMPENFABRIEKEN)<br>* page 3, lignes 2 - 44; figure 5 *<br>--- | 1-4 | |
| A | PATENT ABSTRACTS OF JAPAN<br>vol. 6, no. 16 (E-92)(894) 29 janvier 1982,<br>& JP-A-56 137717 (NIPPON DENKI K.K) 27 octobre 1981,<br>* le document en entier *<br>--- | 1-4 | |
| A | US-A-4034307 (SCHADE, JR)<br>* colonne 2, ligne 46 - colonne 3, ligne 4;<br>figures 1, 2 *<br>----- | 1, 4 | |

| | | | DOMAINES TECHNIQUES RECHERCHES (Int. Cl.5) |
|---|---|---|---|
| | | | G05F |

Le présent rapport a été établi pour toutes les revendications

| Lieu de la recherche | Date d'achèvement de la recherche | Examinateur |
|---|---|---|
| LA HAYE | 18 AVRIL 1990 | CLEARY F.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................
& : membre de la même famille, document correspondant

EPO FORM 1503 03.82 (P0402)